(19) **Europäisches Patentamt European Patent Office Office européen des brevets**

(11) **EP 1 089 427 B1**

(12) **FASCICULE DE BREVET EUROPEEN**

(45) Date de publication et mention
de la délivrance du brevet:
**18.07.2007 Bulletin 2007/29**

(51) Int Cl.:
**H03D 3/00** *(2006.01)*

(21) Numéro de dépôt: **00203259.7**

(22) Date de dépôt: **20.09.2000**

(54) **Procédé de comparaison des amplitudes de deux signaux électriques**

Verfarhen zum Vergleichen der Amplituden von zwei elektrischen Signalen

Method for the comparison of the amplitudes of two electrical signals

(84) Etats contractants désignés:
**DE ES FR GB IT**

(30) Priorité: **28.09.1999 FR 9912066**

(43) Date de publication de la demande:
**04.04.2001 Bulletin 2001/14**

(73) Titulaire: **Koninklijke Philips Electronics N.V.
5621 BA Eindhoven (NL)**

(72) Inventeurs:
• **Constantinidis, Nicolas,
Société Civile S.P.I.D.
75008 Paris (FR)**
• **Crinon, Guillaume,
Société Civile S.P.I.D.
75008 Paris (FR)**
• **Chabanne, Sylvain,
Société Civile S.P.I.D.
75008 Paris (FR)**

(74) Mandataire: **Pennings, Johannes et al
NXP Semiconductors
Intellectual Property Department
High Tech Campus 60
5656 AG Eindhoven (NL)**

(56) Documents cités:
**US-A- 5 287 069        US-A- 5 446 761**

**Description**

La présente invention concerne un dispositif de correction d'une différence d'amplitude entre deux signaux. L'invention concerne également un appareil récepteur destiné à la réception d'un signal radiofréquence.

Des comparaisons des amplitudes de deux signaux électriques sont couramment opérées dans toutes sortes de circuits électroniques, par exemple dans le but de réaliser des asservissements de gain. S'il est aisé de comparer les amplitudes de deux signaux synchrones, au moyen de simples comparateurs, il en va différemment lorsque lesdits signaux sont déphasés. De tels signaux atteignent alors des maxima et minima à des instants différents et une comparaison instantanée de ces signaux n'est plus représentative de leur éventuelle différence d'amplitude. La plupart des procédés permettant la comparaison de tels signaux font appel à des étapes de mémorisation des valeurs maximales des signaux, impliquant dans certains cas des conversions analogique/numérique desdits signaux afin d'en mémoriser et d'en comparer les maxima ou minima sous forme numérique. De tels procédés nécessitent pour leur mise en oeuvre des structures complexes, et donc coûteuses, à la fois en termes de surface de silicium nécessaire à leur implémentation et en termes de consommation d'énergie.

La présente invention a pour but de remédier à ces inconvénients en proposant une solution permettant la comparaison des amplitudes de deux signaux qui ne requiert aucune mémorisation desdits signaux.

En effet, la revendication 1 définit un dispositif selon l'Invention.

Un dispositif selon l'invention utilise le fait que la puissance véhiculée par un signal est représentative de son amplitude. Ainsi, selon l'invention, il n'est plus nécessaire de disposer à un même instant des valeurs des amplitudes de chacun des signaux en vue d'en faire une comparaison instantanée, ce qu'un déphasage entre les signaux rend difficile. Il suffit d'élaborer pour chaque signal une information représentative de la puissance qu'il véhicule, information qui est indépendante de sa phase.

Il convient de noter que US-A-5 287 069 décrit un amplificateur qui combine des ondes à amplitude constante. Un circuit de contrôle compare une onde d'entrée avec une onde de sortie pour détecter une distorsion dans l'onde de sortie. Le circuit de contrôle ajuste le gain d'un amplificateur à gain variable afin d'éliminer la distorsion détectée. Plus en détail, un circuit à loi carrée établit le carré de l'onde d'entrée. Un autre circuit à loi carrée établit le carré d'une version atténuée de l'onde de sortie. Un circuit de soustraction calcule la différence entre ces carrés respectifs. La différence est appliquée à l'amplificateur à gain variable. Ce réglage permet à l'onde auxiliaire d'adopter une caractéristique circulaire désirée.

Si la présente Invention peut être utilisée dans tous types de circuits électriques, sa mise en oeuvre est particulièrement avantageuse pour corriger des différences d'amplitudes qui peuvent apparaître lors d'une démodulation d'un signal radiofréquence. La revendication 4 définit un appareil selon l'invention.

L'invention sera mieux comprise à l'aide de la description suivante, faite à titre d'exemple non-limitatif et en regard des dessins annexés, dans lesquels :

- la figure 1 est un schéma fonctionnel partiel décrivant un appareil récepteur de signaux radiofréquence mettant en oeuvre l'invention, et
- la figure 2 est un schéma électrique décrivant un module produit inclus dans un tel appareil.

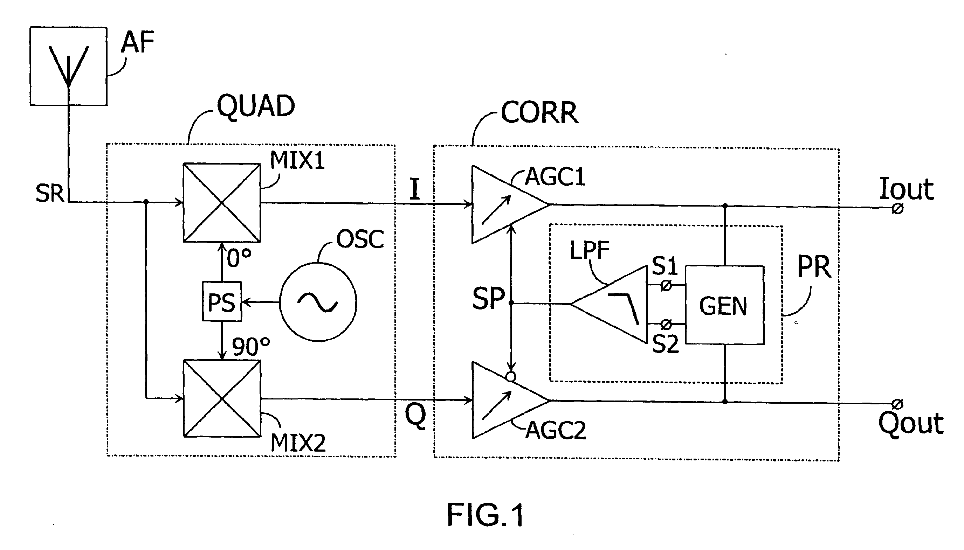

La figure 1 représente schématiquement un appareil récepteur destiné à la réception d'un signal radiofréquence, incluant :

un module quadratique QUAD destiné à délivrer deux signaux de sortie, 1 et Q, en quadrature de phase l'un par rapport à l'autre, dont les phases sont représentatives de données véhiculées
. un dispositif de correction CORR d'une différence d'amplitude entre les signaux de sortie I et Q du module quadratique QUAD.

L'appareil récepteur comporte un dispositif d'antenne et de filtrage AF, destiné à assurer la réception du signal radiofréquence et sa conversion en un signal électronique SR, dit signal radio, exploitable par l'appareil. Le module quadratique QUAD comporte un premier et un deuxième mélangeur, MIX1 et MIX2, respectivement destinés à délivrer les signaux de sortie I et Q du module quadratique QUAD, un oscillateur OSC destiné à délivrer un signal de sortie à une fréquence donnée, qui est le plus souvent réglable, et un déphaseur PS réalisant un déphasage de 90° du signal de sortie de l'oscillateur OSC. Le premier mélangeur MIX1 reçoit le signal radio SR et le signal de sortie non-déphasé de l'oscillateur OSC, tandis que le deuxième mélangeur MIX2 reçoit le signal radio SR et un signal présentant un déphasage de 90° par rapport au signal de sortie de l'oscillateur OSC. Ainsi, les signaux de sortie I et Q du module quadratique QUAD ont une même fréquence, égale à la différence entre la fréquence du signal radio SR et celle du signal de sortie de l'oscillateur OSC, et sont en quadrature de phase l'un par rapport à l'autre, et leur phase est représentative d'informations véhiculées par le signal radio SR. Ce type de traitement du signal radio, préparatoire à sa démodulation, est couramment utilisé dans des démodulateurs de type QAM, QPSK ou encore BPSK. Le traitement du signal radio SR effectué par le module quadratique QUAD peut occasionner une différence d'amplitude entre ses signaux de sortie I et Q, qui sera néfaste à la démodulation à la quelle doit procéder l'appareil. Une telle différence sera corrigée par le dispositif de correction CORR, qui comporte :

- un premier et un deuxième amplificateur à gain variable, AGC1 et AGC2, munis d'entrées de signal destinées à recevoir les signaux de sortie I et Q du module quadratique QUAD, et de sorties destinées à délivrer des signaux de sortie Iout et Qout du dispositif de correction CORR, et

- un module produit PR destiné à recevoir les signaux de sortie Iout et Qout et à générer un signal de sortie SP dont la valeur est représentative d'une différence entre les puissances véhiculées par lesdits signaux Iout et Qout, et donc du résultat d'une comparaison entre les amplitudes de ces signaux.

Les premier et deuxième amplificateurs AGC1 et AGC2 sont munis d'entrées de réglage de gain destinées à recevoir le signal de sortie SP du module produit PR. Ces entrées de réglage sont, dans l'exemple décrit ici, inversées l'une par rapport à l'autre, de sorte qu'une différence d'amplitude entre les signaux Iout et Qout provoque l'amplification de celui des deux signaux dont l'amplitude est la plus faible, et, simultanément, l'atténuation de celui des deux signaux dont l'amplitude est la plus forte. Ceci permet d'utiliser une même structure pour construire les amplificateurs AGC1 et GAC2, seul le câblage des entrées de réglage étant différent d'un amplificateur à l'autre. Il est en effet nécessaire, pour que l'appareil opère une démodulation optimale, que les signaux de sortie Iout et Qout suivent des voies aussi symétriques que possibles. Les amplificateurs AGC1 et AGC2 peuvent être réalisées sous diverses formes, bien connues de l'homme du métier, par exemple en utilisant des cellules de Gilbert.

Dans cet exemple de réalisation, le module produit PR comporte un module dit de génération GEN présentant deux bornes de sortie S1 et S2, destinées à délivrer un signal de sortie représentatif de la différence entre les carrés des signaux Iout et Qout. Le module produit PR comporte également un filtre passe-bas LPF, destiné à recevoir le signal généré par le module de génération GEN. Ce filtre pourra par exemple être constitué par une capacité disposée entre les bornes de sortie S1 et S2 du module de génération GEN. Il est bien connu qu'un filtre passe-bas a un effet de moyenne sur le signal qu'il reçoit. Le signal SP délivré par le filtre passe-bas LPF est donc représentatif de la différence entre les puissances véhiculées par les signaux Iout et Qout, puissances qui s'expriment sous la forme des valeurs moyennes des carrés des amplitudes de ces signaux Iout et Qout. Le signal SP est donc représentatif du résultat d'une comparaison entre les amplitudes des signaux de sortie Iout et Qout du dispositif de correction CORR. Aucune mémorisation n'est requise pour élaborer le signal SP, bien que les signaux Iout et Qout soient en quadrature de phase l'un par rapport à l'autre.

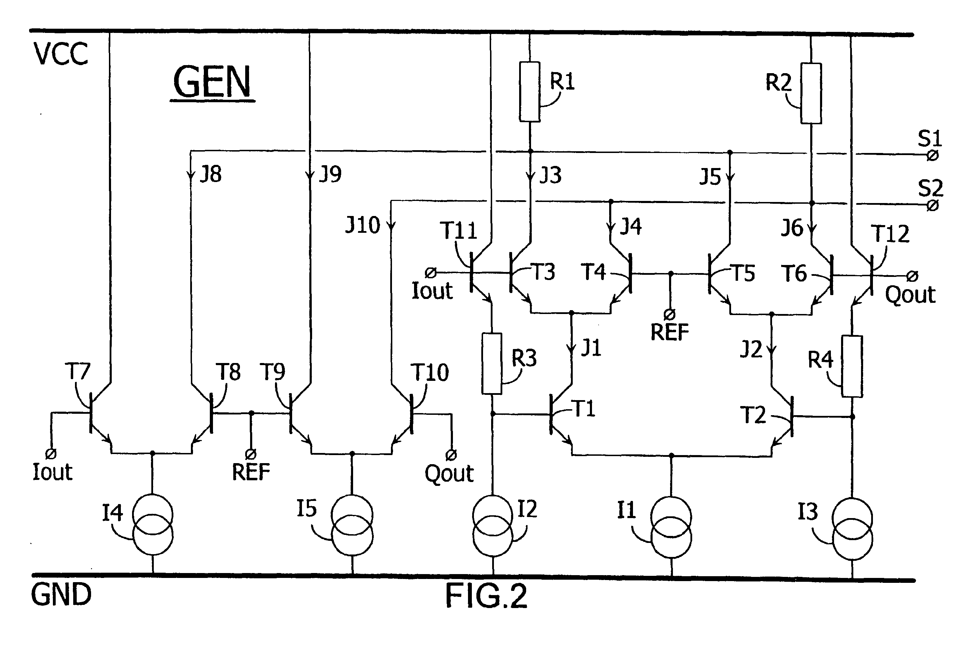

La figure 2 est un schéma électrique qui représente un mode de réalisation du module de génération GEN, qui comprend dans cet exemple :

- un premier et un deuxième transistor T1 et T2 formant une première paire différentielle,
- un troisième et un quatrième transistor T3 et T4 formant une deuxième paire différentielle,
- un cinquième et un sixième transistor T5 et T6 formant une troisième paire différentielle,
- un septième et un huitième transistor T7 et T8 formant une quatrième paire différentielle,
- un neuvième et un dixième transistor T9 et T10 formant une cinquième paire différentielle. Chaque transistor est muni d'une borne de contrôle, d'une borne de transfert et d'une borne de référence. Dans cet exemple, les transistors utilisés sont des transistors bipolaires, dont les bases, collecteurs et émetteurs forment respectivement les bornes de contrôle, de transfert et de référence. On pourrait également utiliser des transistors de type MOS, dont les grilles, drains et sources formeraient alors les bornes de contrôle, de transfert et de référence.

La borne de transfert du premier transistor T1 est reliée aux bornes de référence des troisième et quatrième transistors T3 et T4, la borne de transfert du deuxième transistor T2 étant reliée aux bornes de référence des cinquième et sixième transistors T5 et T6.

Les bornes de contrôle des premier, troisième et septième transistors, T1, T3 et T7, sont destinées à recevoir le signal Iout.

Les bornes de contrôle des deuxième, sixième et dixième transistors, T2, T6 et T10, sont destinées à recevoir le signal Qout.

Les bornes de contrôle des quatrième, cinquième, huitième et neuvième transistors, T4, T5, T8 et T9, sont destinées à recevoir un même signal de référence REF. Ce signal REF sera avantageusement choisi comme étant un signal continu, dont la valeur nominale est égale à celle de composantes continues présentes dans les signaux Iout et Qout.

Les bornes de transfert des troisième, cinquième et huitième transistors, T3, T5 et T8, sont reliées à une borne d'alimentation VCC via une première résistance R1.

Les bornes de transfert des quatrième, sixième et dixième transistors, T4, T6 et T10, sont reliées à ladite borne d'alimentation VCC via une deuxième résistance R2.

Les bornes de transfert des troisième et sixième transistors T3 et T6 forment les bornes de sortie S1 et S2 du module de génération GEN.

Les bornes de transfert des septième et neuvième transistors T7 et T9 sont reliées à la borne d'alimentation VCC.

Les première, quatrième et cinquième paires différentielles sont polarisées par des première, quatrième et cinquième sources de courant I1, I4 et I5. Ces sources de courant seront avantageusement configurées de sorte qu'elles débitent des courants ayant tous une même valeur nominale, notée J.

Le courant transitant via la borne de transfert du ième transistor Ti (pour i=1 à 10) est noté Ji. Le signal de sortie délivré par le module de génération GEN entre ses bornes de sortie S1 et S2 s'exprime sous la forme : V(S1)-V(S2)=VCC-R1.(J3+J5+J8)-[VCC-R2.(J4+J6+J10)]. Si les valeurs nominales des première et deuxième résistances R1 et R2 sont choisies égales à une même valeur R, le signal de sortie s'exprime sous la forme : R.[(J4+J6+J10)-(J3+J5+J8)]. L'expression des courants transitant via les bornes de transfert des transistors constituant les diverses paires différentielles peut se déduire des formules suivantes :

$$J1 = J/2.[1+\tanh((Iout-Qout)/2.Vt)],$$

et

$$J2 = J/2.[1-\tanh((Iout-Qout)/2.Vt)],$$

où

tanh représente la fonction tangente hyperbolique, et Vt=k.T/q, k étant la constante de Boltzmann, T la température absolue et q la charge élémentaire.

Par ailleurs, au voisinage de zéro, la fonction tanh(x) est équivalente à x. Or, les signaux Iout et Qout peuvent respectivement s'exprimer sous la forme REF+iout et REF+qout, où iout et qout sont des composantes alternatives dont l'amplitude est faible devant la valeur du signal de référence REF.

La combinaison des équations susmentionnées permet d'obtenir l'expression suivante du signal de sortie du module de génération GEN :

$$V(S1)-V(S2) = J/2.(iout^2-qout^2)/(2.Vt)^2,$$

Ce signal de sortie est donc proportionnel à la différence entre les carrés des composantes alternatives des signaux Iout et Qout, et est donc représentatif de la différence entre les carrés des amplitudes desdits signaux. Ce signal de sortie V(S1)-V(S2) est appliqué à une entrée du filtre passe-bas LPF, dont une sortie délivre le signal SP, qui est donc représentatif d'une comparaison entre les puissances véhiculées par les signaux Iout et Qout.

Les quatrième et cinquième paires différentielles permettent de soustraire une partie du contenu harmonique que contiendrait le signal de sortie d'un module de génération qui ne serait constitué que des première, deuxième et troisième paires différentielles. Un tel module de génération délivrerait cependant un signal de sortie dont la composante principale serait représentative de la différence entre les carrés des amplitudes des signaux Iout et Qout, mais aurait une moins grande pureté spectrale.

Il est à noter que, parmi d'autres avantages, la symétrie de la structure décrite dans cet exemple de réalisation du module de génération GEN, ainsi que le fait de choisir pour valeur de REF celle des composantes continues des signaux Iout et Qout, rend le signal de sortie V(S1)-V(S2) du module de génération GEN très peu sensible à des variations que la valeur du signal de référence REF pourrait présenter.

**Revendications**

1.  Dispositif de correction d'une différence d'amplitude entre un premier signal d'entrée (I) et un deuxième signal d'entrée (Q), incluant :

    - un premier amplificateur à gain variable (AGC1) muni d'une entrée de signal destinée à recevoir le premier signal d'entrée (I) et muni d'une sortie pour délivrer un premier signal de sortie (Iout) ;
    - un deuxième amplificateur à gain variable (AGC2) muni d'une entrée de signal destinée à recevoir le deuxième signal d'entrée (Q) et muni d'une sortie pour délivrer un deuxième signal de sortie (Qout) ;
    - un module produit (PR) agencé pour générer un signal de réglage (SP) dont la valeur est représentative d'une différence entre les valeurs moyennes des carrés des amplitudes desdits signaux de sortie (Iout, Qout) ;
    - le premier amplificateur à gain variable (AGC1) et le deuxième amplificateur à gain variable (AGC2) ayant chacun une entrée de réglage de gain destinée à recevoir ledit signal de réglage (SP) ; les entrées de réglage étant inversées l'une par rapport à l'autre, de sorte qu'une différence d'amplitude entre lesdits signaux de sortie (Iout, Qout) provoque l'amplification de celui dont l'amplitude est la plus faible, et, simultanément, l'atténuation de celui dont l'amplitude est la plus forte.

2.  Dispositif de correction selon la revendication 1, **caractérisé en ce que** le module produit (PR) inclut :

    - un premier et un deuxième transistor (T1, T2) formant une première paire différentielle ;
    - un troisième et un quatrième transistor (T3, T4) formant une deuxième paire différentielle ; et
    - un cinquième et un sixième transistor(T5, T6) formant une troisième paire différentielle, chaque transistor étant muni d'une borne de contrôle, d'une borne de transfert et d'une borne de référence ;
    la borne de transfert du premier transistor (T1) étant reliée aux bornes de référence des troisième et quatrième transistors (T3, T4), la borne de transfert du deuxième (T2) transistor étant reliée aux bornes de référence des cinquième et sixième transistors (T5, T6) ;

les bornes de contrôle des premier et troisième transistors (T1, T3) étant destinées à recevoir le premier signal de sortie (Iout) ;

les bornes de contrôle des deuxième et sixième transistors (T2, T6) étant destinées à recevoir le deuxième signal de sortie (Qout) ;

les bornes de contrôle des quatrième et cinquième transistors (T4, T5) étant destinées à recevoir un même signal de référence (REF) ;

les bornes de transfert des troisième et cinquième transistors (T3, T5) étant reliées à une borne d'alimentation(VCC) via une première résistance ;

les bornes de transfert des quatrième et sixième transistors étant reliées à ladite borne d'alimentation via une deuxième résistance (R1);

le module produit (PR) incluant en outre un filtre passe-bas (LPF), destiné à recevoir un signal d'entrée prélevé aux bornes de transfert des troisième et sixième transistors (T3, T6), et à délivrer le signal de réglage (SP) du module produit (PR).

**3.** Dispositif de correction selon la revendication 2, **caractérisé en ce que** le module produit (PR) inclut en outre :

- un septième et un huitième transistor (T7, T8) formant une quatrième paire différentielle ; et
- un neuvième et un dixième transistor (T9, T10) formant une cinquième paire différentielle;

la borne de contrôle du septième transistor (T7) étant destinée à recevoir le premier signal de sortie (Iout) ;

la borne de contrôle du dixième transistor (T10) étant destinée à recevoir le deuxième signal de sortie (Qout) ;

les bornes de contrôle des huitième et neuvième transistors (T8, T9) étant destinées à recevoir un même signal de référence (REF) ;

les bornes de transfert des huitième et dixième transistors (T8, T10) étant respectivement reliées à la borne d'alimentation (VCC) via les première et deuxième résistances (R1, R2).

**4.** Appareil récepteur destiné à la réception d'un signal radiofréquence (SR), incluant :

- un module quadratique (QUAD) destiné à délivrer deux signaux de sortie (I, Q) en quadrature de phase l'un par rapport à l'autre, dont les phases sont représentatives de données véhiculées par le signal radiofréquence (SR) ; et
- un dispositif de correction (CORR) selon la revendication 1 agencé pour recevoir un desdits deux signaux de sortie en tant que premier signal d'entrée, et l'autre desdits deux signaux de sortie en tant que deuxième signal d'entrée.

**Claims**

**1.** A correction device for correcting a difference in amplitude between a first input signal (1) and a second input signal (Q), including:

- a first variable gain amplifier (AGC1) having a signal input intended to receive the first input signal (I) and having an output for supplying a first output signal (Iout);
- a second variable gain amplifier (AGC2) having a signal input intended to receive the second input signal (Q) and having an output for supplying a second output signal (Qout);
- a product module (PR) arranged for generating a tuning signal (SP) whose value is representative of a difference between the average values of the squares of the amplitudes of said output signals (Iout, Qout);
- the first variable gain amplifier (AGC 1) and the second variable gain amplifier (AGC2) having each a gain control input intended to receive said tuning signal (SP); the control inputs being inverted with respect to each other so that a difference in amplitude between said output signals (Iout, Qout) causes the amplitude of the weaker of the two output signals to be amplified and, simultaneously the amplitude of the stronger of the two output signals to be reduced.

**2.** A correction device as claimed in claim 1, **characterized in that** the product module (PR) includes:

- a first and a second transistor (T1, T2) forming a first differential pair;
- a third and a fourth transistor (T3, T4) forming a second differential pair;
- a fifth and a sixth transistor (T5, T6) forming a third differential pair; each transistor having a control terminal, a transfer terminal and a referenmce terminal;

the transfer terminal of the first transistor (T1) being connected to the terminals of the third and fourth transistors (T3, T4), the transfer terminal of the second transistor (T2) being connected to the reference terminal of the fifth and sixth transistors (T5, T6); the control terminals of the first and third transistors (T1, T3) being intended to receive the first output signal (Iout); the control terminals of the second and sixth transistors (T2, T6) being intended to receive the second output signal (Qout); the control terminals of the fourth and fifth transistors (T4, T5) being intended to receive an equal reference signal (REF);

the transfer terminals of the third and fifth transistors (T3, T5) being connected to a supply terminal (VCC) via a first resistor (R1);

the transfer terminals of the fourth and sixth transistors (T4, T6) being connected to said supply terminal (VCC) via a second resistor (R2);

the product module (PR) further including a low-pass filter (LPF) intended to receive an input signal tapped from the transfer terminals of the third and sixth transistors (T3, T6), and to supply the control signal (SP) of the product module (PR).

3. A correction device as claimed in claim 2, **characterized in that** the product module (PR) comprises, inter alia:

- a seventh and an eighth transistor (T7, T8) forming a fourth differential pair;
- a ninth and a tenth transistor (T9, T10) forming a fifth differential pair;

the control terminal of the seventh transistor (T7) being intended to receive the first input signal (Iout);
the control terminal of the tenth transistor (T10) being intended to receive the second output signal (Qout);
the control terminals of the eighth and ninth transistors (T8, T9) being intended to receive an equal reference signal (REF);
the transfer terminals of the eighth and tenth transistors (T8, T10) being connected, respectively, to the supply terminal (VCC) via the first and second resistors (R1, R2).

4. A receiving device intended to receive a radio frequency signal (SR), which device comprises:

- a quadratic module (QUAD) for supplying two output signals (I, Q) in quadrature phase to each other, the phases of which are representative of data conveyed by the radio frequency signal (SR), and
- a correction device (CORR) as claimed in claim 1, arranged for receiving one of said two output signals as well as the first input signal, and the other one of the two output signals as well as the second input signal.

**Patentansprüche**

1. Vorrichtung zur Korrektur einer Amplitudendifferenz zwischen einem ersten Eingangssignal (I) und einem zweiten Eingangssignal (Q), die einschließt:

- einen ersten Verstärker mit variabler Verstärkung (AGCI), der mit einem Signaleingang zum Empfang des ersten Eingangssignals (I) und mit einem Ausgang zur Ausgabe eines ersten Ausgangssignals (Iout) versehen ist,
- einen zweiten Verstärker mit variabler Verstärkung (AGC2), der mit einem Signaleingang zum Empfang des zweiten Eingangssignal (Q) und mit einem Ausgang zur Ausgabe eines zweiten Ausgangssignals (Qout)versehen ist,
- ein Produktmodul (PR) zur Erzeugung eines Regelungssignals (SP), dessen Wert für eine Differenz der Durchschnittswerte der Rechtecke der Amplituden dieser Ausgangssignale (Iout, Qout) repräsentativ ist,
- wobei der erste Verstärker mit variabler Verstärkung (AGC1) und der zweite Verstärker mit variabler Verstärkung (AGC2) jeweils einen Verstärkungsregelungseingang haben, der dieses Regelungssignal (SP) empfängt; wobei die Regelungseingänge jeweils zueinander derart umgekehrt sind, dass eine Amplitudendifferenz zwischen diesen Ausgangssignalen (Iout, Qout) die Verstärkung des Signals, dessen Amplitude die kleinste ist, und gleichzeitig die Dämpfung des Signals, dessen Amplitude die größte ist, verursacht.

2. Korrekturvorrichtung nach Anspruch 1, **dadurch gekennzeichnet, dass** das Produktmodul (PR) einschließt:

- einen ersten und einen zweiten Transistor (T1, T2), die ein erstes Differentialpaar bilden,
- einen dritten und einen vierten Transistor (T3, T4), die ein zweites Differentialpaar bilden, und
- einen fünften und einen sechsten Transistor (T5, T6), die ein drittes Differentialpaar bilden, wobei jeder Transistor mit einer Prüfklemme, einer Übertragungsklemme und einer Bezugsklemme ausgestattet ist,

wobei die Übertragungsklemme des ersten Transistors (T1) mit den Bezugsklemmen des dritten und vierten Transistors (T3, T4), die Übertragungsklemme des zweiten Transistors (T2) mit den Bezugsklemmen des fünften und sechsten Transistors (T5, T6) verbunden ist,

wobei die Prüfklemmen des ersten und dritten Transistors (T1, T3) zum Empfang des ersten Ausgangssignals (Iout) bestimmt sind,

wobei die Prüfklemmen des zweiten und sechsten Transistors (T2, T6) zum Empfang des zweiten Ausgangssignals (Qout) bestimmt sind,

wobei die Prüfklemmen des vierten und fünften Transistors (T4, T5) zum Empfang desselben Bezugssignals (REF) bestimmt sind,

wobei die Übertragungsklemmen des dritten und fünften Transistors (T3, T5) über einen ersten Widerstand mit einer Versorgungsklemme (VCC) verbunden sind,
wobei die Übertragungsklemmen des vierten und sechsten Transistors über einen zweiten Widerstand (R1) mit dieser Versorgungsklemme verbunden sind,
wobei das Produktmodul (PR) ferner einen Tiefpassfilter (LPF) einschließt, der zum Empfang eines Eingangssignals bestimmt ist, das an den Übertragungsklemmen des dritten und sechsten Transistors (T3, T6) abgenommen wird, und zur Ausgabe des Regelungssignal (SP) des Produktmoduls (PR).

3. Korrekturvorrichtung nach Anspruch 2, **dadurch gekennzeichnet, dass** das Produktmodul (PR) ferner einschließt:

    - einen siebten und einen achten Transistor (T7, T8), der ein viertes Differentialpaar bildet, und
    - einen neunten und einen zehnten Transistor (T9, T10), der ein fünftes Differentialpaar bildet,

wobei die Prüfklemme des siebten Transistors (T7) zum Empfang des ersten Ausgangsignals (Iout) bestimmt ist,
wobei die Prüfklemme des zehnten Transistors (T10) zum Empfang des zweiten Ausgangssignals (Qout) bestimmt ist,
wobei die Prüfklemmen des achten und neunten Transistors (T8, T9) zum Empfang desselben Bezugssignals (REF) bestimmt sind,
wobei die Übertragungsklemmen des achten und zehnten Transistors (T8, T10) jeweils mit der Versorgungsklemme (VCC) über den ersten und zweiten Widerstand (R1, R2) verbunden sind.

4. Empfangsgerät zum Empfang eines Radiofrequenzsignals (SR), das einschließt:

    - ein quadratisches Modul (QUAD) zur Ausgabe von zwei Ausgangssignalen (I, Q) in Phasenquadratur zueinander, deren Phasen für Daten repräsentativ sind, die durch das Radiofrequenzsignal (SR) übertragen werden, und
    - eine Korrekturvorrichtung (CORR) nach Anspruch 1 zum Empfang eines dieser zwei Ausgangssignale als erstes Eingangssignal und des anderen dieser zwei Ausgangssignale als zweites Eingangssignal.

FIG.1

FIG.2

EP 1 089 427 B1

**EP 1 089 427 B1**

**RÉFÉRENCES CITÉES DANS LA DESCRIPTION**

**Documents brevets cités dans la description**

- US 5287069 A